Europäisches Patentamt

European Patent Office

Office européen des brevets

(19)

(11) Numéro de publication : **0 102 296**
**B1**

(12) **FASCICULE DE BREVET EUROPÉEN**

(45) Date de publication du fascicule du brevet :
03.12.86

(51) Int. Cl.⁴ : **G 01 R 31/28**

(21) Numéro de dépôt : **83401687.5**

(22) Date de dépôt : **19.08.83**

(54) Procédé de fabrication d'une matrice de composants électroniques.

(30) Priorité : 25.08.82 FR 8214582

(43) Date de publication de la demande :
07.03.84 Bulletin 84/10

(45) Mention de la délivrance du brevet :
03.12.86 Bulletin 86/49

(84) Etats contractants désignés :
**DE GB IT NL**

(56) Documents cités :
DE-A- 2 137 619
DE-A- 2 409 280
DE-A- 2 739 952
US-A- 3 835 530
US-A- 4 191 996

(73) Titulaire : **COMMISSARIAT A L'ENERGIE ATOMIQUE
Etablissement de Caractère Scientifique Technique
et Industriel
31/33, rue de la Fédération
F-75015 Paris (FR)**

(72) Inventeur : **Duchene, Jacques
Chemin du Mas
F-38330 Saint Ismier (FR)**
Inventeur : **Lacour, Jacques
19, rue Lumière
F-38100 Grenoble (FR)**

(74) Mandataire : **Mongrédien, André et al
c/o BREVATOME 25, rue de Ponthieu
F-75008 Paris (FR)**

## Description

La présente invention a pour objet un procédé de fabrication d'une matrice de composants électroniques. Elle s'applique à tout arrangement matriciel de composants électroniques et en particulier à une matrice d'éléments utilisée pour la commande d'un écran d'affichage, tels que des transistors commandant un écran d'affichage à cristal liquide ou électroluminescent, ou tels que des détecteurs optiques.

Dans une matrice de composants comportant p lignes et q colonnes de composants reliés électriquement entre eux, l'excitation électrique d'un composant ij situé au croisement de la ligne i, i étant un entier tel que $1 \leqslant i \leqslant p$, et de la colonne j, j étant un entier tel que $1 \leqslant j \leqslant q$, est effectuée en excitant (application d'une tension) simultanément la ligne i de composants et la colonne j de composants. Lorsque l'on désire exciter successivement tous les composants, l'excitation se fait en général en excitant simultanément toutes les colonnes et en excitant séquentiellement les lignes, c'est-à-dire en effectuant un balayage ligne par ligne.

En conséquence, dans une telle matrice de composants, la présence d'un composant défectueux entraîne des perturbations, non seulement au niveau de ce composant mais aussi au niveau de la ligne et de la colonne de composants qui lui correspondent, ce qui crée un défaut beaucoup plus important.

Pour éviter de tels problèmes, on utilise une redondance au niveau de chaque composant, c'est-à-dire que l'on multiplie le nombre de composants au niveau de chaque croisement ij entre les lignes et les colonnes. En conséquence, si l'un des composants d'un croisement donné est défectueux, on peut le remplacer par un autre composant correspondant à ce même croisement.

La réalisation d'une matrice de composants électroniques, à partir de plusieurs séries de composants, consiste, après la fabrication des composants, à tester les composants d'un même croisement, à choisir pour chaque croisement le composant non défectueux et à relier électriquement entre eux les composants choisis.

Cette technique de redondance présente de nombreux inconvénients puisque tous les composants devant constituer la matrice doivent être testés pour être ensuite connectés entre eux. En effet, ce test pose le problème d'accès à chaque composant. Par ailleurs, le test de chaque composant est long et fastidieux.

De plus l'utilisation de plusieurs composants pour un croisement d'une ligne et d'une colonne données pose un certain nombre de problèmes technologiques et notamment des problèmes d'encombrement.

On connaît, par ailleurs, un procédé de fabrication d'un circuit intégré qui, partant d'un groupe de sous-éléments non connectés entre eux formés chacun de composants électroniques connectés entre eux, consiste à déterminer des sous-éléments non défectueux et à les connecter entre eux de façon à former le circuit désiré. Ce procédé est décrit dans le document US-A-3 835 530.

La présente invention a justement pour objet un procédé de fabrication d'une matrice de composants électroniques permettant de remédier à ces inconvénients. En particulier, elle permet de tester les différents composants devant constituer la matrice de façon relativement simple.

De façon plus précise, l'invention a pour objet un procédé de fabrication d'un système de composants électroniques dont tous les composants fonctionnent correctement, qui consiste à :

— réaliser n groupes de r sous-éléments redondants de composants non reliés électriquement entre eux, les composants électroniques d'un même sous-élément étant reliés électriquement entre eux ; et,

— déterminer dans chaque groupe de sous-éléments un sous-élément non défectueux, et connecter entre eux les sous-éléments ainsi déterminés de façon à former le système de composants, caractérisé en ce que, le système de composants étant une matrice de composants de p lignes et q colonnes et les sous-éléments des sous-matrices, la détermination et la connexion des sous-éléments non défectueux consistent à :

— choisir de façon arbitraire, dans chaque groupe de sous-matrices, une des r sous-matrices redondantes ;

— connecter entre elles les sous-matrices choisies ;

— tester la matrice ainsi obtenue de façon à déterminer les sous-matrices éventuellement défectueuses ;

— détruire les connexions de ces sous-matrices défectueuses ;

— connecter des sous-matrices non défectueuses à d'autres sous-matrices, choisies de façon arbitraire dans les groupes comprenant les sous-matrices défectueuses ; et,

— répéter les opérations qui précèdent jusqu'à l'obtention d'une matrice de composants de p lignes et q colonnes dont tous les composants fonctionnent correctement.

Afin d'obtenir une probabilité élevée de trouver parmi les sous-matrices d'un même groupe une sous-matrice non défectueuse, on utilisera, de préférence, au moins trois sous-matrices par groupe.

Le procédé de l'invention permet de limiter le nombre d'opérations à effectuer pour déterminer les sous-matrices non défectueuses à raccorder. En effet, l'obtention d'une matrice dont tous les composants fonctionnent correctement se fait en choisissant des ensembles de composants non défectueux, c'est-à-dire des sous-matrices non défectueuses, et non en choisissant les composants, composant par composant.

De préférence, la destruction des connexions des sous-matrices défectueuses est réalisée au moyen d'un faisceau laser.

Selon un mode préféré de mise en œuvre du procédé de l'invention, le test de la matrice obtenue consiste à :

— exciter séquentiellement chaque ligne de composants et recueillir séquentiellement le signal de sortie au niveau de chaque ligne de façon à tester chaque ligne,

— exciter séquentiellement chaque colonne de composants et recueillir séquentiellement le signal de sortie au niveau de chaque colonne de façon à tester chaque colonne, et

— exciter séquentiellement chaque ligne de composants et recueillir le signal de sortie en parallèle sur les colonnes de façon à réaliser un test entre les lignes et les colonnes.

Ce test permet de détecter les anomalies des lignes et des colonnes de la matrice obtenue.

Afin de tester chaque composant de la matrice obtenue, on peut conformément à l'invention, effectuer une étape de test supplémentaire. Cette étape consiste à exciter séquentiellement chaque ligne de composants et à recueillir le signal de sortie en parallèle sur les colonnes, en envoyant un faisceau d'électrons délocalisés sur toute la matrice obtenue, de façon à tester le bon fonctionnement de chaque composant.

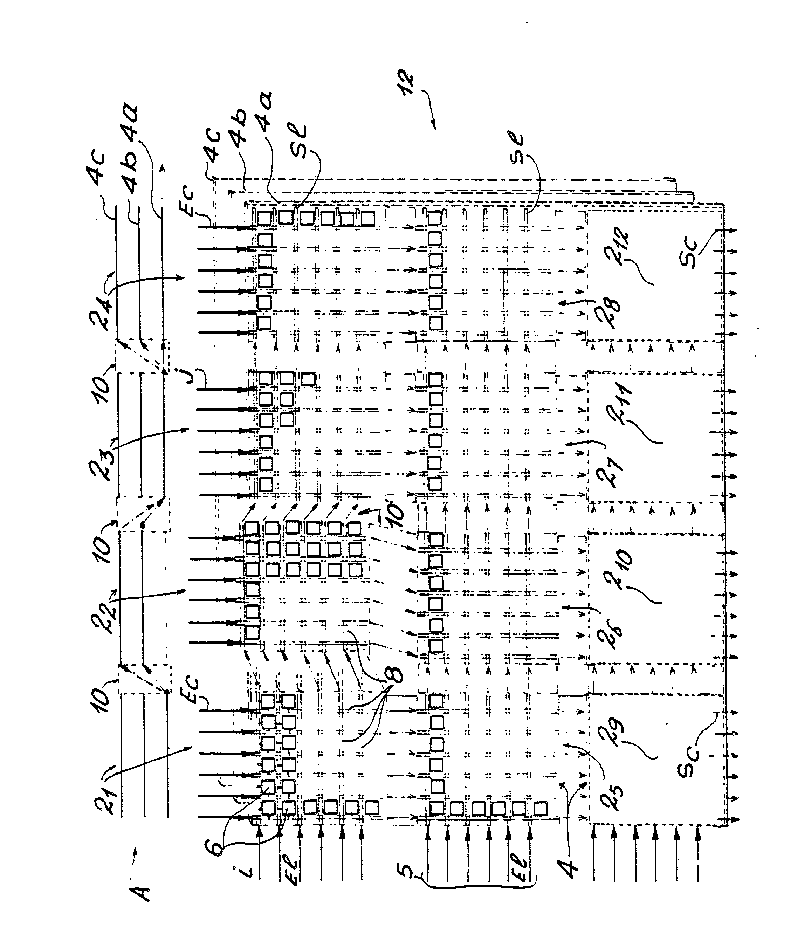

D'autres avantages et caractéristiques de l'invention ressortiront de la description qui suit, donnée à titre illustratif et non limitatif en référence à l'unique figure qui représente les différentes étapes du procédé de l'invention.

En se référant à l'unique figure, le procédé de fabrication selon l'invention consiste à réaliser tout d'abord n groupes 2 de r sous-matrices 4 de composants électroniques 6, r et n étant des nombres entiers positifs. Sur cette figure, on a représenté douze groupes de sous-matrices, portant les références $2_1$, $2_2$, ... $2_{12}$, formés chacun de trois sous-matrices 4a, 4b et 4c. Dans une même sous-matrice 4 les composants électroniques 6 sont reliés électriquement entre eux au moyen de conducteurs électriques 8. La réalisation de chaque sous-matrice de composants électroniques se fait de façon classique.

Ensuite, on détermine, dans chaque groupe 2 de sous-matrices 4, une sous-matrice 4 fonctionnant correctement et on connecte entre elles les sous-matrices 4 choisies. La connexion des sous-matrices choisies se fait par l'intermédiaire d'interrupteurs 10 à plusieurs branchements, ici trois branchements possibles.

Sur la figure, on a représenté une connexion possible de la sous-matrice 4a du groupe $2_1$ à la sous-matrice 4b du groupe $2_2$, cette dernière étant reliée à la sous-matrice 4a du groupe $2_3$, etc... Sur la partie A de cette figure, on a représenté une vue schématique de dessus de la matrice permettant de mieux voir la connexion des différentes sous-matrices entre elles.

Les sous-matrices 4a, 4b, 4c d'un même groupe 2 constituent une redondance de sous-matrices permettant d'obtenir à coup sûr une matrice finale de composants électroniques 6, dont tous les composants fonctionnent correctement. Cette matrice finale, comme par exemple celle représentée sur la figure et portant la référence 12, comporte p lignes i de composants et q colonnes j de composants.

Afin d'obtenir une probabilité élevée d'avoir, dans chaque groupe 2 de sous-matrices, une sous-matrice 4 dont tous les points fonctionnent correctement, c'est-à-dire une probabilité voisine de 1, on utilisera de préférence une redondance au moins égale à trois, c'est-à-dire que le nombre r est au moins égal à trois.

La réalisation d'une matrice, conformément à l'invention, peut être avantageusement utilisée pour l'obtention d'une matrice de composants électroniques, tels que des transistors, utilisés dans l'adressage d'éléments, par exemple de cristal liquide, dans un écran d'affichage. Ces transistors peuvent être, soit des MOSFET (transistor à effet de champ en technologie métal oxyde semiconducteur) réalisés sur du silicium monocristallin, soit des transistors réalisés en couche mince.

On va maintenant décrire la façon de déterminer, selon l'invention, les sous-matrices non défectueuses de chaque groupe à connecter électriquement entre elles.

La première étape de cette détermination consiste à choisir, arbitrairement, dans chaque groupe 2 de sous-matrices, une sous-matrice 4 et à connecter électriquement entre elles les sous-matrices choisies. Dans le cas de trois sous-matrices par groupe, il y a douze combinaisons possibles pour relier une sous-matrice d'un groupe à l'une des trois sous-matrices des quatre groupes voisins.

La seconde étape consiste à tester, comme on le verra ultérieurement, la matrice ainsi obtenue de façon à déterminer les sous-matrices éventuellement défectueuses, cette matrice peut être par exemple celle représentée sur la figure. Ensuite, on détruit les connexions des sous-matrices défectueuses révélées par le test. Cette destruction se fait par exemple en envoyant un faisceau laser sur les connexions illicites. Par exemple, si le test révèle que la sous-matrice 4b du groupe $2_2$ ne fonctionne pas ou fonctionne mal, on détruit les trois connexions de cette sous-matrice 4b, la reliant, réciproquement, à la sous-matrice 4a du groupe $2_1$, à la sous-matrice 4a du groupe $2_3$ et à la sous-matrice 4a du groupe $2_6$.

L'étape suivante du procédé consiste à choisir, arbitrairement, dans les groupes comportant les sous-matrices défectueuses, par exemple dans le groupe $2_2$ comportant la sous-matrice défectueuse 4b, une autre sous-matrice, par exemple la sous-matrice 4c de ce groupe $2_2$, et à connecter ces nouvelles sous-matrices choisies, aux autres sous-matrices, par exemple à connecter la sous-matrice 4c du groupe $2_2$, respectivement, à la sous-matrice 4a du groupe $2_1$ (partie A de la figure), à la sous-matrice 4a du groupe $2_3$ et à la sous-matrice 4a du groupe $2_6$.

Les opérations décrites précédemment doivent être répétées jusqu'à ce que l'on obtienne une matrice finale dont tous les composants fonctionnent correctement. Bien entendu, il peut se faire que la première matrice réalisée soit la bonne.

On va maintenant décrire une façon de réaliser le test de la matrice obtenue, lors de la connexion des sous-matrices de façon arbitraire afin de déterminer les sous-matrices éventuellement défectueuses.

La première étape de ce test consiste à déterminer la continuité électrique de chaque ligne i de composants électroniques 6 de la matrice obtenue. Ceci peut être réalisé en excitant séquentiellement les lignes i, de la même façon qu'on le ferait lors du fonctionnement ultérieur de la matrice, et en recueillant le signal de sortie au niveau de chaque ligne. Par exemple, le signal d'excitation peut être envoyé par les entrées $E_l$, à gauche de la figure, et le signal de sortie peut être recueilli sur les sorties $S_l$, à droite de la figure. Si aucune anomalie n'est détectée, on passe à l'étape suivante du test.

La seconde étape du test consiste à déterminer la continuité électrique de chaque colonne j de composants électroniques. Comme pour le contrôle des lignes, ceci peut être réalisé en excitant séquentiellement les colonnes et en recueillant le signal de sortie au niveau de chaque colonne. Par exemple on peut entrer le signal d'excitation par les entrées $E_c$, en haut de la figure, et le signal de sortie peut être recueilli sur les sorties $S_c$, en bas de la figure. Comme précédemment, si aucune anomalie n'est détectée, on peut passer à l'étape suivante du test.

La troisième étape du test consiste à réaliser un contrôle entre les lignes et les colonnes de la matrice obtenue. Ceci peut être effectué en excitant séquentiellement les lignes i et en recueillant le signal de sortie en parallèle sur les colonnes j. Par exemple, on peut entrer le signal d'excitation par les entrées $E_l$ et recueillir le signal de sortie simultanément sur les sorties $S_c$.

Ces trois étapes de test sont suffisantes pour détecter les anomalies des lignes et des colonnes, anomalies qui sont les plus graves pour une matrice de composants électroniques. Ces trois étapes de test peuvent être réalisées par une simple lecture de différence de potentiel entre les signaux d'entrée et de sortie. Une différence de potentiel importante entre l'entrée et la sortie du signal correspond à une anomalie de la matrice obtenue.

Dans le cas de composants électroniques servant à la commande d'un écran d'affichage, par exemple des transistors, ces trois étapes de test peuvent être effectuées en adressant les éléments d'affichage, cristal liquide par exemple, et en effectuant une lecture optique. Dans ce cas, l'apparition d'éléments d'affichage noirs (c'est-à-dire non excités) correspond à une anomalie de la matrice obtenue.

Comme autre technique de test, on peut utiliser un faisceau d'électrons, ou encore la thermographie infrarouge.

Afin d'effectuer un test plus poussé au niveau de chaque composant électronique de la matrice, on peut réaliser une étape de test supplémentaire.

Cette étape consiste, à exciter séquentiellement les lignes i et à recueillir le signal de sortie en parallèle sur les colonnes j, comme dans l'étape précédente, en envoyant, simultanément à l'excitation, un faisceau d'électrons délocalisés sur toute la matrice de composants. Cette étape supplémentaire correspond au fonctionnement ultérieur de la matrice, lorsque celle-ci est entièrement réalisée.

Les circuits électriques (non représentés) permettant d'effectuer les différentes étapes du test de la matrice obtenue peuvent être les mêmes que ceux utilisés pour le fonctionnement ultérieur de la matrice ou bien d'autres circuits facilement réalisables par l'homme de l'art.

**Revendications**

1. Procédé de fabrication d'un système de composants électroniques dont tous les composants fonctionnent correctement, consistant à :

réaliser n groupes (2) de r sous-éléments (4) redondants de composants (6), non reliés électriquement entre eux, les composants électroniques (6) d'un même sous-élément (4) étant reliés électriquement entre eux ; et,

déterminer dans chaque groupe (2) de sous-éléments (4) un sous-élément non défectueux, et connecter entre eux les sous-éléments ainsi déterminés de façon à former le système de composants (6) ;

caractérisé en ce que, le système de composants étant une matrice de composants de p lignes et q colonnes et les sous-éléments des sous-matrices, la détermination et la connexion des sous-éléments non défectueux consistent à :

choisir de façon arbitraire, dans chaque groupe (2) de sous-matrices (4), une des r sous-matrices (4) redondantes ;

connecter entre elles les sous-matrices (4) choisies ;

tester la matrice ainsi obtenue de façon à déterminer les sous-matrices (4) éventuellement défectueuses ;

détruire les connexions de ces sous-matrices (4) défectueuses ;

connecter des sous-matrices (4) non défectueuses à d'autres sous-matrices (4), choisies de façon arbitraire dans les groupes (2) comprenant les sous-matrices défectueuses ; et,

répéter les opérations qui précèdent jusqu'à l'obtention d'une matrice de composants de p lignes et q colonnes dont tous les composants fonctionnent correctement.

2. Procédé selon la revendication 1, caractérisé en ce que r est au moins égal à 3.

3. Procédé selon la revendication 1 ou 2, caractérisé en ce que la destruction des connexions des sous-matrices (4) défectueuses est réalisée au moyen d'un faisceau laser.

4. Procédé selon l'une quelconque des revendications 1 à 3, caractérisé en ce que le test de la matrice obtenue consiste à :

exciter ($E_l$) séquentiellement chaque ligne (i) de composants (6) et recueillir séquentiellement le signal de sortie ($S_l$) au niveau de chaque ligne (i) de façon à tester chaque ligne ;

exciter ($E_c$) séquentiellement chaque colonne (j) de composants (6) et recueillir séquentiellement le signal de sortie ($S_c$) au niveau de chaque colonne (j) de façon à tester chaque colonne ; et,

exciter ($E_l$) séquentiellement chaque ligne (i) de composants (6) et recueillir le signal de sortie ($S_c$) en parallèle sur les colonnes (j) de façon à réaliser un test entre les lignes et les colonnes.

5. Procédé selon la revendication 4, caractérisé en ce que le test de la matrice comprend une étape supplémentaire qui consiste à exciter ($E_l$) séquentiellement chaque ligne (i) de composants (6) et à recueillir le signal de sortie ($S_c$) en parallèle sur les colonnes (j) en envoyant un faisceau d'électrons, délocalisés sur toute la matrice obtenue, de façon à tester le bon fonctionnement de chaque composant (6).

6. Procédé selon l'une quelconque des revendications 1 à 5, caractérisé en ce que les composants (6) sont des transistors de commande d'un écran d'affichage.

**Claims**

1. Process for the production of a system of electronic components, all the components of which operate correctly, the said process comprising the following steps :

forming n groups (2) of r redundant sub-elements (4) of components (6), not electrically connected to each other, the electronic components (6) of an individual sub-element (4) being electrically connected to each other ; and

determining within each group (2) of sub-elements (4) a non-defective sub-element, and connecting to each other the sub-elements thus determined in such a manner as to form the system of components (6) ;

characterized in that, the system of components being a matrix of components of p lines and q columns and the sub-elements of the sub-matrices, the determination and the connection of the non-defective sub-elements comprise the following steps :

selecting in an arbitrary manner, within each group (2) of sub-matrices (4), one of the r redundant sub-matrices (4) ;

connecting to each other the selected sub-matrices (4) ;

testing the matrix thus obtained in such a manner as to determine the sub-matrices (4) which may possibly be defective ;

destroying the connections of these defective sub-matrices (4) ;

connecting non-defective sub-matrices (4) to other sub-matrices (4) selected in an arbitrary manner within the groups (2) including the defective sub-matrices ; and repeating the aforementioned operations until there is obtained a matrix of components of p lines and q columns, all the components of which operate correctly.

2. Process according to claim 1, characterized in that r is at least equal to 3.

3. Process according to claim 1 or 2, characterized in that the destruction of the connections of the defective sub-matrices (4) is effected by means of a laser beam.

4. Process according to any one of claims 1 to 3, characterized in that the test of the matrix obtained comprises the following steps :

exciting ($E_l$) sequentially each line (i) of components (6) and collecting sequentially the output signal ($S_l$) at the location of each line (i) in such a manner as to test each line ;

exciting ($E_c$) sequentially each column (j) of components (6) and collecting sequentially the output signal ($S_c$) at the location of each column (j) in such a manner as to test each column ; and

exciting ($E_l$) sequentially each line (i) of components (6) and collecting the output signal ($S_c$) in parallel on the columns (j) in such a manner as to carry out a test between the lines and the columns.

5. Process according to claim 4, characterized in that the test of the matrix includes a supplementary step which consists in exciting ($E_l$) sequentially each line (i) of components (6) and in collecting the output signal ($S_c$) in parallel on the columns (j) by sending a beam of electrons, which are delocalized over the entire matrix obtained, in such a manner as to test the proper operation of each component (6).

6. Process according to any one of claims 1 to 5, characterized in that the components (6) are command transistors of a display screen.

**Patentansprüche**

1. Verfahren zum Herstellen eines Systems aus elektronischen Komponenten, die sämtlich fehlerfrei arbeiten, durch :

Erstellen von n Gruppen (2) aus r redundanten, elektrisch nicht miteinander verbundenen Unterelementen (4) aus Komponenten (6), wobei die elektronischen Komponenten (6) eines solchen Unterelements (4) untereinander elektrisch verbunden sind ; und

Bestimmen eines fehlerfreien Unterelements in jeder Gruppe (2) aus Unterelementen (4) und Verbinden der so bestimmten Unterelemente miteinander derart, daß das System aus Komponenten (6) gebildet wird ;

dadurch gekennzeichnet, daß das System aus Komponenten eine Matrix aus Komponenten in p Zeilen und q Spalten ist und die Unterelemente Untermatrizen sind, wobei die Bestimmung der Verbindung der fehlerfreien Unterelemente besteht aus :

beliebige Auswahl einer der r redundanten Untermatrizen (4) in jeder Gruppe (2) aus Untermatrizen (4) ;

Verbinden der ausgewählten Untermatrizen (4) untereinander ;

Prüfen der so erhaltenen Matrix derart, daß die evtl. fehlerhaften Untermatrizen (4) ermittelt werden ;

Zerstören der Anschlüsse dieser fehlerhaften Untermatrizen (4) ;

Verbinden der fehlerfreien Untermatrizen (4) mit anderen Untermatrizen (4), die beliebig aus den fehlerhafte Untermatrizen enthaltenden Gruppen (2) ausgewählt werden ; und

Wiederholen der vorangehenden Operationen, bis man eine Matrix aus Komponenten in p Zeilen und q Spalten erhält, deren sämtliche Komponenten fehlerfrei arbeiten.

2. Verfahren nach Anspruch 1, dadurch gekennzeichnet, daß r wenigstens gleich 3 ist.

3. Verfahren nach Anspruch 1 oder 2, dadurch gekennzeichnet, daß die Zerstörung der Anschlüsse der fehlerhaften Untermatrizen (4) mittels eines Laserstrahls ausgeführt wird.

4. Verfahren nach einem der Ansprüche 1 bis 3, dadurch gekennzeichnet, daß die Prüfung der erhaltenen Matrix besteht aus :

sequentielles Erregen ($E_l$) jeder Zeile (i) der Komponenten (6) und sequentielles Erfassen des Ausgangssignals ($S_l$) in Höhe jeder Zeile (i), um jede Zeile zu prüfen ;

sequentielles Erregen ($E_c$) jeder Spalte (j) aus Komponenten (6) und sequentielles Erfassen des Ausgangssignals ($S_c$) in Höhe jeder Spalte (j), um jede Spalte zu prüfen ; und

sequentielles Erregen ($E_l$) jeder Zeile (i) aus Komponenten (6) und Erfassen des Ausgangssignals ($S_c$) parallel an den Spalten (j), um eine Prüfung unter den Zeilen und den Spalten auszuführen.

5. Verfahren nach Anspruch 4, dadurch gekennzeichnet, daß die Prüfung der Matrix einen zusätzlichen Schritt umfaßt, der besteht aus sequentielles Erregen ($E_1$) jeder Zeile (i) aus Komponenten (6) und Erfassen des Ausgangssignals ($S_c$) parallel an den Spalten (j), indem ein Bündel aus Elektronen, die über die gesamte erhaltene Matrix ausgebreitet werden, ausgesendet wird, um die gute Funktion einer jeden Komponente (6) zu prüfen.

6. Verfahren nach einem der Ansprüche 1 bis 5, dadurch gekennzeichnet, daß die Komponenten (6) Steuertransistoren eines Anzeigeschirms sind.